# EUROPÄISCHE PATENTSCHRIFT

(11) **EP 1 724 616 B1**
(45) Veröffentlichungstag und Bekanntmachung des Hinweises auf die Patenterteilung: **22.04.2015**
(21) Anmeldenummer: 05013794.2
(22) Anmeldetag: 27.06.2005
(51) Int. Cl.: G02B 5/20, C23C 14/04, G03F 7/00, C23C 16/04, C23C 14/00, C23C 16/515

(54) **Verfahren zur Herstellung strukturierter optischer Filterschichten auf Substraten**
Process for manufacturing patterned optical filter layers on substrates
Procédé d'obtention d'un filtre optique structuré sur un substrat

(30) Priorität: 17.05.2005 DE 102004034418
(43) Veröffentlichungstag der Anmeldung: 22.11.2006
(73) Patentinhaber: Schott AG, 55122 Mainz (DE)
(72) Erfinder: Wittenberg, Dieter, 37520 Osterode (DE); Küpper, Thomas, 37581 Bad Gandersheim (DE); Zogg, Lutz, 37581 Bad Gandersheim (DE); Mehrtens, Andree, Dr., 31073 Grünenplan (DE)
(74) Vertreter: Herden, Andreas F.

(56) Entgegenhaltungen:
- EP-A- 0 037 529
- WO-A-99/42864
- WO-A-99/54786
- GB-A- 1 544 607
- JP-A- 2003 057 424
- US-A- 5 711 889
- US-A1- 2004 126 676
- US-A1- 2004 145 823

## Beschreibung

Die Erfindung betrifft allgemein die Herstellung von strukturierten optischen Beschichtungen auf Substraten, insbesondere betrifft die Erfindung die Herstellung in ihrer flächigen Erstreckung strukturierter, insbesondere segmentierter optischer Filterschichten auf Substraten.

Flächig segmentierte optische Beschichtungen auf Substraten werden unter anderem bei optischen Filtern, wie beispielsweise optischen Rotationsfiltern oder Farbrädern für Videoprojektoren benötigt. Mit einem solchen Filter werden aus einem Lichtstrahl sequentiell verschiedenfarbige Lichtstrahlen ausgefiltert und mittels einer digitalen Mikrospiegel-Einrichtung (DMD) auf einen Schirm projeziert.

Ein solches Farbrad ist zur sequentiellen Ausfilterung in verschiedene Segmente unterteilt, welche die verschiedenen Farben je nach Stellung des rotierenden Farbrades ausfiltern. Um ein flackerfreies Bild zumindest in Videoqualität zu erzeugen, muß das Licht dabei sehr schnell in verschiedene Lichtstrahlen unterschiedlicher Farbe zerlegt werden. Dies erfordert eine schnelle Rotation des Filters und damit einhergehend unter anderem eine genaue Ausrichtung und Auswuchtung der Filterscheibe, damit diese den auftretenden mechanischen Belastungen bei der Rotation gewachsen ist. Ein weiteres Erfordernis für solche Farbräder ist ein möglichst nahtloser Übergang zwischen den einzelnen Segmenten.

Bei einem gängigen Herstellungsverfahren für einen solchen Filter werden verschiedene jeweils einheitlich beschichtete Filterscheiben mit bestimmten Filtereigenschaften in Segmente geschnitten und die Segmente anschließend wieder zu einer Filterscheibe zusammengesetzt. Derartige Farbräder und Herstellungsverfahren dazu sind beispielsweise aus der DE 19708949 Al oder der US 5868482 A bekannt. Das Zerschneiden und Zusammensetzen ist jedoch aufwendig und insbesondere der Zusammenbau erfordert besondere Sorgfalt, da erstens ein möglichst nahtloser Übergang gefordert wird und zweitens eine genaue Auswuchtung der zusammengesetzten Filterscheibe nötig ist. Weiterhin muß die Verbindung zwischen den einzelnen Segmenten auch der bei der Rotation auftretenden mechanischen Belastung standhalten.

Eine weitere Möglichkeit um ein Farbrad herzustellen, ist, ein Substrat mit segmentierten Filterschichten zu versehen. Dazu ist es aus der WO 99/42861 A1 bekannt, das Substrat mittels Lift-off-Technik mit einem Farbfilterschichtsystem zu versehen. Die Filterschicht wird dabei durch Sputtern oder plasmaunterstütztes Bedampfen hergestellt. Durch Auflösen der Photolack-Maskierung und Abheben der darauf befindlichen Filterschicht bleibt dann ein Segment der Filterschicht auf dem Substrat stehen. Dieses Verfahren wird für jedes Filtersegment wiederholt. Allerdings ist das Verfahren auf den Einsatz bei niedrigen Substrattemperaturen unter 150 °C beschränkt.

Ein Verfahren zur Herstellung eines Filters, mit Abscheidetemperaturen von 300-400°C ist in US 2004 0126676 A1 beschrieben.

Der Erfindung liegt die Aufgabe zugrunde, hinsichtlich der Nachteile der aus dem Stand der Technik bekannten Verfahren verbesserte Beschichtungsverfahren bereitzustellen.

Diese Aufgabe wird in höchst überraschend einfacher Weise durch den Gegenstand der unabhängigen Ansprüche gelöst.

Vorteilhafte Ausgestaltungen und Weiterbildungen sind in den Unteransprüchen angegeben.

Die Erfindung sieht dementsprechend ein Verfahren zur Herstellung zumindest eines optischen Filterschicht-Segments auf einem Substrat vor, bei welchem
- eine Maskierung mit einer Lackschicht auf einer Fläche des Substrats hergestellt,
- durch Vakuumabscheiden eine optische Filterschicht auf der Fläche abgeschieden, und
- die Lackschicht mit der darauf befindlichen optischen Filterschicht durch Aufquellen der Lackschicht entfernt wird.
   Es hat sich gezeigt, daß das übliche Entfernen der Lackschicht durch Auflösen nach einer hohen Temperaturbelastung beim Vakuumabscheiden der Schicht problematisch sein kann. Erfindungsgemäß wird jedoch die Lackschicht im Unterschied dazu mittels Aufquellen vom Substrat gelöst. Diese Art des Entfernens ist jedoch in überraschender Weise weniger empfindlich gegenüber temperaturbedingen Veränderungen der Lackschicht. Dementsprechend können beispielsweise auch höhere Temperaturen bei der Beschichtung toleriert werden, was unter anderem wiederum die Möglichkeit eröffnet, die Abscheideraten bei einer höheren Temperatur auf der zu beschichtenden Fläche zu erhöhen und damit den Herstellungsprozeß zu beschleunigen. Durch das Abscheiden bei einer hohen Temperatur kann auch eine höhere Qualität und Haltbarkeit der Farbfilterschichten erzielt werden. Insbesondere werden Störstellen in den Schichten reduziert. So können bei der Vakuumabscheidung bei höheren Temperaturen dichtere Schichten hergestellt werden. Derartige Schichten sind dann auch stabiler und resistenter gegenüber chemischen Einflüssen. So zeigen solche Schichten vielfach eine geringere oder nicht mehr vorhandene Wasseraufnahmefähigkeit. Die Ursache für die höhere Dichte liegt in der höheren Beweglichkeit der auf die zu beschichtende Fläche beim Beschichten auftreffenden Teilchen.
   Eine Weiterbildung dieser Ausführungsform der Erfindung sieht vor, daß das Herstellen der Maskierung mit einer Lackschicht das Aufbringen eines Photolacks, das Belichten und Entwickeln des Photolacks umfaßt. Das erfindungsgemäße Verfahren kann also beispielsweise problemlos mit den in der Photolithographie üblichen Verfahrensweisen und der damit erzielbaren exakten Strukturgebung kombiniert werden.
   Gemäß einer anderen Weiterbildung der Erfindung umfaßt das Herstellen der Maskierung mit einer Lackschicht das Aufbringen eines Stoplacks. Ein Stoplack, wie er etwa als Lötstoplack in der Leiterplattenfertigung verwendet wird, hat sich als gut vakuumtauglich erwiesen. Typischerweise weisen solche Lacke auch eine gute Temperaturbeständigkeit auf und können daher auch durch Auf- oder Anlösen nach der Beschichtung entfernt werden.
   Um die Lackschicht durch Aufquellen zu entfernen, hat sich insbesondere das Behandeln der Lackschicht mit einer Lauge als geeignet erwiesen.
   Eine weitere Möglichkeit, das Ablösen der Maskierung der zu beschichtenden Fläche des Substrats zu verbessern, ist die Applikation einer abziehbaren Lackmaskierung. Dementsprechend sieht die Erfindung auch ein Verfahren zur Herstellung eines optischen Filterschicht-Segments auf einem Substrat vor, bei welchem
- die Lackschicht samt der darauf befindlichen optischen Filterschicht vom Substrat abgezogen wird.
   Auch dieses Verfahren hat sich als vergleichsweise unempfindlich gegenüber temperaturbedingten Veränderungen der Lackmaskierung erwiesen, so daß beispielsweise höhere Temperaturen bei der Beschichtung verwendbar sind.
   Um die zu beschichtende Fläche des Substrats mit einer Lackmaskierung zu versehen, sind verschiedene Möglichkeiten der Applikation des Lacks geeignet. Gemäß einer bevorzugten Ausführungsform der Erfindung wird Lack für die Lackschicht aufgedruckt. Das Bedrucken ermöglicht in vorteilhafter Weise bereits bei der Applikation des Lacks eine Konturgebung.
   Insbesondere von Vorteil ist es dabei gemäß einer Weiterbildung, den Lack für die Lackschicht mittels eines Druckkopfs nach Art eines Tintenstrahl-Druckkopfes aufzudrucken. Mit solchen Druckköpfen können bereits sehr feine und exakte Konturen der Lackmaskierung direkt und sogar ohne weitere Schritte, wie etwa einer nachfolgenden photolithographischen Strukturgebung auf dem Substrat erzeugt werden. Ein solcher Druckkopf kann beispielsweise ein Piezo-Jet-Druckkopf oder ein Bubble-Jet-Druckkopf sein.
   Das Aufdrucken kann auch rechnergestützt erfolgen. Dies ist insbesondere auch in Verbindung mit einem solchen Druckkopf nach Art eines Tintenstrahl-Druckkopfes leicht realisierbar. Mit dieser Weiterbildung der Erfindung kann demgemäß eine bestimmte gewünschte Segmentierung einer optischen Filterschicht direkt vom Rechner auf das zu beschichtende Substrat übertragen werden.
   Gemäß noch einer Weiterbildung der Erfindung kann Lack für die Lackschicht auch durch oder über eine auf der Fläche aufliegende Schablone aufgetragen werden. Dazu wird eine Schablone auf der Fläche angeordnet und Lack auf die mit der Schablone versehenen Fläche aufgetragen. Mit dem Auftrag durch eine Schablone können die Substrate beispielsweise sehr schnell mit einer bereits in ihrer flächigen Erstreckung strukturierten Lackmaskierung versehen werden. Da solche Masken mit einer hohen Genauigkeit herstellbar sind, kann gleichzeitig auch eine gute Genauigkeit für die Konturen des entsprechenden optischen Filtersegments erreicht werden.
   Weitere geeignete Verfahren zum Auftrag der Lackschicht, die auch mit den oben beschriebenen Auftragsverfahren kombiniert werden können, sind der Lackauftrag mittels Pinseln, Rollen, Siebdruck oder Sprühen, insbesondere Airless-Sprühen.
   Gemäß noch einer Weiterbildung der Erfindung wird die mit Lack beschichtete Fläche beim Vakuumabscheiden der optischen Filterschicht erwärmt, woraufhin die auf der Lackschicht abgeschiedene optische Filterschicht beim Abkühlen Risse erhält. Die ansonsten unerwünschte Rißbildung hat sich hier als günstig erwiesen, um beispielsweise das Eindringen eines Quellmittels für den Lack zu beschleunigen. Auf diese Weise wird das Entfernen der Lackschicht samt darauf befindlicher optischer Filterschicht deutlich beschleunigt.
   Um unter anderem eine noch bessere Temperaturbeständigkeit der Maskierung zu erreichen, sieht die Erfindung auch die direkte Maskierung mit einer separaten Konturmaske vor. Demgemäß wird bei einem Verfahren zur Herstellung eines optischen Filterschicht-Segments auf einem Substrat gemäß noch einer Ausführungsform der Erfindung
- eine Maskierung der Fläche durch Fixieren einer Konturmaske auf der Fläche des Substrats hergestellt,
- durch Vakuumabscheiden eine optische Filterschicht auf der Fläche abgeschieden, und
- die Konturmaske mit der darauf befindlichen optischen Filterschicht von der Fläche getrennt.
   Die Konturmaske kann dabei gemäß einer Weiterbildung der Ausführungsform auch in der Vakuumabscheidekammer auf der Fläche angeordnet werden. Dies ist beispielsweise von Vorteil, wenn mehrere verschiedene Filtersegmente auf das Substrat aufgebracht werden sollen. Das Substrat muß dann nicht aus der Kammer entnommen werden, um eine weitere Maskierung für ein anderes Filtersegment herzustellen. Insbesondere kann das Anordnen der Konturmaske sogar im Vakuum erfolgen, so daß das Substrat weder geschleust, noch die Kammer belüftet werden muß.
   Die Konturmaske kann vorteilhaft mittels magnetischer Kräfte auf der Fläche 3 gehalten werden. Dies erlaubt insbesondere auch ein einfaches Entfernen der Konturmaske nach erfolgter Vakuumabscheidung der optischen Filterschicht. Beispielsweise kann die Konturmaske mit einer unter der zu beschichtenden Fläche des Substrats angeordneten Magnetanordnung fixiert werden. Die Anordnung "unter dieser Fläche" bedeutet dabei nicht, daß eine bestimmte Orientierung in Bezug auf die Schwerkraftrichtung gegeben ist, sonder vielmehr eine relative Angabe bezüglich der zu beschichtenden Fläche. Anders ausgedrückt wird die Konturmaske entweder mit einer im Substrat selbst befindlichen und/oder mit einer über oder auf einer der zu beschichtenden Fläche gegenüberliegenden Seite des Substrats angeordneten Magnetanordnung fixiert. Die Magnetanordnung kann zum Beispiel eine Polschuhanordnung, eine Feinpolanordnung, ein Magnetband oder auch einzelne Magnete auf einer Rückschlußplatte umfassen.
   Um magnetische Kräfte auf das Substrat auszuüben, kann die Konturmaske mit Vorteil ein magnetisierbares Material umfassen. Geeignet ist dabei unter anderem magnetisierbares Dünnblech.
   Allgemein kann die Konturmaske aus Materialien gefertigt werden, die ausreichend vakuumtauglich sind. Bevorzugt werden Materialien verwendet, die auch eine ausreichende Temperaturstabilität aufweisen. So wird gemäß einer Weiterbildung der Erfindung bevorzugt eine Metallfolie oder Kunststofffolie, insbesondere mit einem temperaturbeständigen Kunstoff für die Konturmaske verwendet. Aufgrund seiner Temperaturbeständigkeit ist beispielsweise Polyimid ein besonders geeigneter Kunstoff. Eine Konturmaske mit genauen Konturen kann weiterhin vorteilhaft aus einer Folie durch Fräsen oder Laserstrahlschneiden oder Wasserstrahlschneiden oder Ätzen oder einer Kombination zumindest zweier dieser Verfahren hergestellt werden.
   Eine alternative oder zusätzliche Methode der Anordnung der Konturmaske gemäß noch einer Ausführungsform der Erfindung ist das Fixieren der Konturmaske auf der Fläche mittels einer Haftschicht. Auch diese Ausführungsform der Erfindung erlaubt nach der Vakuumbeschichtung der Fläche eine leichte Trennung der Konturmaske. Bevorzugt wird dazu die Konturmaske nach dem Abscheiden von der Fläche abgezogen.
   Die Haftschicht kann sogar so ausgebildet sein, daß sie einer Veränderung aufgrund einer Temperatureinwirkung beim Beschichten unterliegt, bei welcher sich die Hafteigenschaften verschlechtern, so daß die Konturmaske nach der Beschichtung zwar noch haftet, sich aber besonders leicht ablösen läßt. Es ist aber alternativ oder zusätzlich auch möglich, die Haftschicht durch ein geeignetes Lösungsmittel auf- oder anzulösen oder mit einem Quellmittel -beispielsweise einer Lauge- aufzuquellen.
   Um die Konturmaske möglichst exakt in der vorgesehenen Position zu fixieren, sind verschiedene Zusatzmaßnahmen vorteilhaft. So kann die Position der Konturmaske mittels
- ein oder mehrerer Paßbohrungen oder mittels
- zumindest einer Anlagekante oder
- zumindest einer Markierung oder Klemmung oder mittels - maschineller Ausrichtung oder mittels
- zumindest einem Vorsprung, beispielsweise einem Führungsdorn auf der Fläche oder Maske oder einem Substrathalter, welcher in eine Aussparung eingreift, oder mittels
- einer Kombination von zumindest zwei dieser Maßnahmen festgelegt oder justiert werden.

Die Konturmaske kann einen anderen Temperaturausdehnungskoeffizienten als das Substratmaterial haben. Dies kann dazu führen, daß sich die Konturmaske gegenüber der zu beschichtenden Fläche des Substrats bewegt, wenn sich das Substrat beim Vakuumbeschichten erwärmt. Um daraus entstehende mögliche Ungenauigkeiten der Konturen des optischen Filterschicht-Segments zu verringern, ist gemäß einer Weiterbildung der Ausführungsform der Erfindung mit Verwendung einer Konturmaske vorgesehen, daß die Position der Konturmaske an einem Fixierungspunkt gegenüber der Fläche fixiert wird, dessen Position so gewählt ist, daß eine lokale Verschiebung der Konturen der Maske aufgrund einer Temperaturänderung beim Vakuumabscheiden der optischen Schicht minimiert ist.

Zur Beschichtung der Fläche des Substrats können alle möglichen Vakuumabscheideverfahren eingesetzt werden. Beispielsweise ist gemäß einer Ausführungsform der Erfindung vorgesehen, daß das Vakuumabscheiden der optischen Filterschicht die physikalische Dampfphasenabscheidung (PVD) zumindest einer Schicht umfaßt. Dabei kann die zumindest eine Schicht durch Aufsputtern oder Aufdampfen, auch mit plasmaunterstütztem Aufdampfen abgeschieden werden. Mit Aufsputtern lassen sich qualitativ hochwertige Schichten auch aus schwer verdampfbaren Materialien herstellen. Aufdampfen ist andererseits unter anderem günstig, um hohe Abscheideraten zu erzielen und damit den Produktionsprozeß zu beschleunigen.

Gemäß noch einer Ausführungsform der Erfindung umfaßt das Vakuumabscheiden der optischen Filterschicht die chemische Dampfphasenabscheidung zumindest einer Schicht. Insbesondere ist dabei auch an das Vakuumabscheiden zumindest einer Schicht mittels plasmaimpuls-induziertem Dampfphasenabscheiden gedacht.

Eine bevorzugte Weiterbildung der Erfindung sieht außerdem vor, daß das Vakuumabscheiden der optischen Filterschicht das Abscheiden einer mehrlagigen Schicht umfaßt. Dabei werden die Lagen bevorzugt sequentiell mittels einer geeigneten Beschichtungsquelle abgeschieden. Insbesondere können zumindest zwei Lagen mit unterschiedlicher Zusammensetzung abgeschieden werden, wobei sich bevorzugt auch der Brechungsindex unterscheidet.

Mit derartigen mehrlagigen Schichten können eine Vielzahl vorteilhafter optischer Filtereigenschaften erzielt werden. Beispielsweise können mit geeignet angepaßten Schichtdicken und Brechungsindizes der Schichten Interferenz-Schichtsysteme hergestellt werden. Eine mittels des erfindungsgemäßen Verfahrens abgeschiedene Interferenz-Filterschicht kann unter anderem als Entspiegelung oder insbesondere bevorzugt auch als Farbfilter dienen. Eine Interferenz-Filterschicht kann außerdem insbesondere auch mehrere Lagen mit alternierendem Brechungsindex zur Erzeugung von Teilreflexionen aufweisen.

Gemäß noch einer Ausführungsform der Erfindung ist ein Verfahren zur Herstellung zumindest eines optischen Filterschicht-Segments auf einem Substrat vorgesehen, bei welchem
- eine Maskierung mit einer Lackschicht auf einer Fläche des Substrats hergestellt,
- durch Vakuumabscheiden eine optische Filterschicht auf der Fläche abgeschieden, und
- die Lackschicht mit der darauf befindlichen optischen Filterschicht entfernt wird,
wobei daß das Abscheiden der optischen Filterschicht bei einer Temperatur von über 150 °C, bevorzugt in einem Bereich von über 150 °C bis einschließlich 400 °C erfolgt. Der Lift-off-Schritt, beziehungsweise das Entfernen der Lackschicht mit der darauf befindlichen Filterschicht kann zum Beispiel durch Aufquellen oder auch durch Auf- oder Anlösen des Lacks mit einem geeigneten Lösungsmittel geschehen.

Eine Weiterbildung dieser Ausführungsform der Erfindung sieht vor, daß das Vakuumabscheiden der optischen Filterschicht zumindest zeitweise im Bereich 170 °C ± 15 °C, bevorzugt im Bereich von 170 °C ± 10 °C erfolgt.

Das Vakuumabscheiden kann insbesondere das plasmaunterstützte Abscheiden, insbesondere Sputtern oder plasmaunterstütztes Aufdampfen umfassen.

Beim Vakuumabscheiden der optischen Filterschicht kann bei allen Ausführungsformen der Erfindung die maskierte Fläche eine Temperatur von über 150 °C, bevorzugt in einem Bereich von über 150 °C bis einschließlich 400 °C aufweisen. Als günstig für die Stabilität des Abscheideprozesses hat es sich dabei erwiesen, wenn die Temperatur der maskierten Fläche zumindest zeitweise im Bereich 170 °C ± 15 °C, bevorzugt im Bereich von 170 °C ± 10 °C liegt. Diese Temperaturbereiche werden bei herkömmlichen Verfahren mit Photolack-Maskierung im allgemeinen gerade gemieden, damit der Lack anschließend auflösbar bleibt.

Gemäß noch einer weiteren Ausführungsform der Erfindung ist vorgesehen, daß ein kreissegmentförmiges Segment der Fläche mit einer optischen Filterschicht beschichtet wird. Eine derartige Form eines Filtersegments ist insbesondere bei rotierenden optischen Filtern von Vorteil, wie etwa bei einem ein scheibenförmigen Substrat für ein Farbrad, wie es etwa in einem digitalen Projektor verwendet wird.

Eine weitere Möglichkeit ist unter anderem das Abscheiden eines optischen Filterschicht-Segments, welches in Form einer sichtbaren Information, insbesondere eines Schriftzugs, Symbols oder Logos geformt ist. Damit lassen sich erfindungsgemäß auch dekorative oder kennzeichnende Effekte erzielen.

Die Verfahrensschritte zur Herstellung eines optischen Filtersegments auf einem Substrat können gemäß einer bevorzugten Ausführungsform der Erfindung auch mehrmals wiederholt werden, um mehrere Filtersegmente auf dem Substrat aufzubringen. Demgemäß sieht die Erfindung auch eine Ausführungsform des Verfahrens vor, bei welchem die Schritte des Maskierens und des Vakuumabscheidens zumindest einmal wiederholt werden, wobei durch unterschiedliche Maskierung unterschiedliche Segmente der Fläche mit einer optischen Filterschicht versehen werden. Um unterschiedliche optische Eigenschaften der einzelnen Filtersegmente bereitzustellen, können die unterschiedlichen Segmente insbesondere mit unterschiedlichen optischen Filterschichten versehen werden.

Das erfindungsgemäße Verfahren eignet sich für die Beschichtung verschiedenster Substrate, sofern diese im Vakuum beschichtet werden können. Ein besonders geeignetes Material zur Beschichtung ist Glas aufgrund seiner Transparenz, Vakuumtauglichkeit und Temperaturbeständigkeit. Dementsprechend ist gemäß einer weiteren Ausführungsform der Erfindung vorgesehen, daß ein Glassubstrat oder eine Glasfläche eines Substrats beschichtet wird. Es können aber auch andere Materialien, etwa mit metallischen oder keramischen Oberflächen, oder auch für die Vakuumabscheidung geeignete Kunstoffe beschichtet werden.

Für das erfindungsgemäße Verfahren ergeben sich eine Vielzahl von Verwendungen. Neben der Herstellung eines segmentierten optischen Filters, beispielsweise eines als Farbrad ausgebildeten Farbfilters können auch beispielsweise Sensoren mit derartigen optischen Filterschicht-Segmenten ausgestattet werden. So kann der Sensor mehrere Sensorflächen aufweisen, von denen zumindest eine von einem optischen Filterschicht-Segment bedeckt ist.

Ein solcher Sensor kann beispielsweise ein Bildsensor sein, bei welchem die optischen Filterschicht-Segmente zur Farbfilterung dienen.

Weitere Verwendungen sind die Beschichtung von Folien und/oder die Beschichtung von Unterlagen mit dekorativen Mustern.

Im folgenden wird die Erfindung anhand von Ausführungsbeispielen und unter Bezugnahme auf die Zeichnungen näher erläutert, wobei gleiche und ähnliche Elemente mit gleichen Bezugszeichen versehen sind und die Merkmale verschiedener Ausführungsbeispiele miteinander kombiniert werden können.

### Es zeigen:

Fig. 1A bis 1D Verfahrensschritte zur Herstellung eines erfindungsgemäß beschichteten Substrats gemäß einer ersten Ausführungsform der Erfindung,
Fig. 2 eine Variante der Verfahrensschritte der Fig. 1A bis 1D,
Fig. 3A, 3B und 4A, 4B Verfahrensschritte zur Maskierung des Substrats gemäß zweier Varianten dieser Ausführungsform,
Fig. 5A und 5B eine Ausführungsform der Erfindung mit magnetischer Fixierung einer Konturmaske,
Fig. 6 bis 9 verschiedene Ausführungsbeispiele für Magnetanordnungen,
Fig. 10 bis 12 Ausführungsbeispiele erfindungsgemäß beschichteter Substrate.

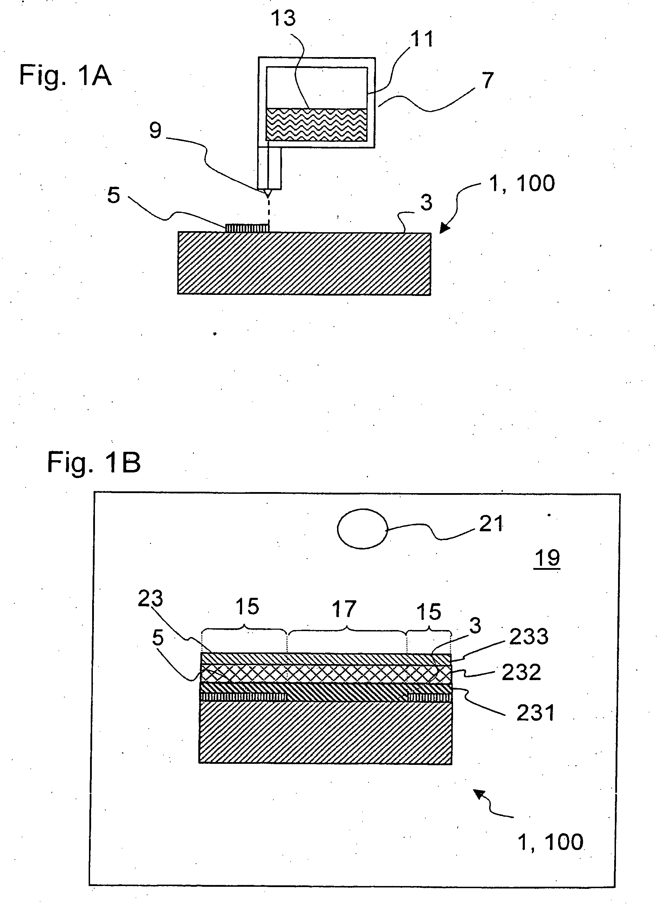

Anhand der Figuren 1A bis 1D, welche schematische Querschnittansichten eines Substrats 1 darstellen, werden Verfahrensschritte zur Herstellung eines erfindungsgemäß beschichteten Substrats 1 gemäß einer ersten Ausführungsform der Erfindung gezeigt.

Das Verfahren zur Herstellung eines Substrats 1 mit einem oder mehreren optischen Filterschicht-Segmenten basiert darauf, daß
- eine Maskierung mit einer Lackschicht auf einer Fläche 3 des Substrats 1 hergestellt,
- durch Vakuumabscheiden eine optische Filterschicht auf der Fläche abgeschieden, und
- die Lackschicht mit der darauf befindlichen optischen Filterschicht durch Aufquellen der Lackschicht entfernt wird.
   Gemäß dieser ersten, in den Fig. 1A bis 1D gezeigten Ausführungsform der Erfindung wird das Substrat 1 mit einer Lackschicht 5 durch das Aufbringen eines Lacks 13 maskiert,
wobei das Aufbringen des Lacks 13 insbesondere rechnergesteuert über die Düsen 9 eines
Druckkopfs 7 erfolgt, der an einen in Fig. 1A nicht dargestellten Rechner angeschlossen ist. Mit einem derartigen Druckkopf kann eine in ihrer flächigen Erstreckung strukturierte, oder segmentierte Lackschicht 5 mit besonders scharfen, gut definierten Rändern hergestellt werden.

Für das Substrat kann ein beliebiges, mittels eines Vakuumabscheideverfahrens beschichtbares Material verwendet werden. Gedacht ist diesbezüglich beispielsweise an Glas, Glaskeramik, Keramik, Kunststoff und/oder Metall. Als Substrat 1 wird bei dem in den Fig. 1A bis 1D gezeigten Ausführungsbeispiel ein scheibenförmiges Glassubstrat 100 für ein Farbrad verwendet.

Der Lack 13 kann beispielsweise ein Stoplack, wie insbesondere ein Lötstoplack aus der Leiterplattenfertigung, ein Abziehlack oder auch ein Photolack sein.

Es können zur Verbesserung des Lackauftrags auch verschiedene weitere Maßnahmen vorgenommen werden. So kann der Lack 13 im Vorratsbehälter 11 und/oder der Zuführleitung zu den Düsen 9 und/oder auch in der Düse, insbesondere durch Kühlung der Düse und/oder der Zuführleitung gekühlt werden, um das Abdampfen des Lösungsmittels des Lacks vor dem Auftrag zu vermindern und damit ein Zusetzen des Druckkopfs 7 zu verhindern. Das Bedrucken kann außerdem in einer geeigneten Umgebung, wie etwa einer komprimierten und/oder lösemittelhaltigen Atmosphäre erfolgen.

Um das nach dem Bedrucken im Lack der Lackschicht 5 enthaltene Lösungsmittel möglichst schnell zu entfernen und die Lackschicht zu verfestigen, kann das Substrat beispielsweise beim Bedrucken auch vorerwärmt sein.

Fig. 1B zeigt eine weitere Phase des Herstellungsprozesses. Die Maskierung des Substrats 1 mit der Lackschicht 5 ist abgeschlossen. Durch den strukturierten Auftrag der Lackschicht 5 ist zumindest ein Teilbereich oder Segment 15 der Fläche 3 des Substrats 1 durch den Lack der Lackschicht 5 maskiert, wohingegen zumindest ein anderes Segment 17 offen geblieben, beziehungsweise unbedeckt ist.

Das mit der so gemusterten Lackschicht 5 versehene Substrat 1 wird in einer Vakuumkammer 19 gegenüber oder in einer symbolisch dargestellten Beschichtungsquelle 21 angeordnet. Mittels der Beschichtungsquelle 21 wird dann in der evakuierten Beschichtungskammer 19 eine Vakuumabscheidung einer optischen Filterschicht 23 auf der mit der gemusterten Lackschicht 5 versehenen Fläche 3 des Substrats 1 vorgenommen. Die optische Filterschicht 23 weist bei diesem Ausführungsbeispiel außerdem mehrere Lagen 231, 232, 232 auf, die nacheinander durch Vakuumabscheiden aufgebracht werden, wobei bei diesem Ausführungsbeispiel außerdem zumindest zwei der Lagen 231, 232, 232 mit unterschiedlicher Zusammensetzung abgeschieden werden.

Das Vakuumabscheiden der optischen Filterschicht kann beispielsweise die physikalische Dampfphasenabscheidung (PVD) zumindest einer Schicht umfassen. Die Beschichtungsquelle 21 kann gemäß einer Weiterbildung dazu eine Verdampfungseinrichtung umfassen, wobei dann das Vakuumabscheiden der optischen Filterschicht 23 das Aufdampfen zumindest einer der Schichten 231, 232, 233 umfaßt.

Gemäß einer anderen Weiterbildung umfaßt das Vakuumabscheiden der optischen Filterschicht 23 das Aufsputtern zumindest einer der Schichten 231, 232, 233,
wobei dazu die Beschichtungsquelle 21 zumindest eine Sputterquelle aufweist.

Ebenso kann zumindest einer der Schichten 231, 232, 233 auch durch chemische Dampfphasenabscheidung mittels einer entsprechend eingerichteten Beschichtungsquelle 21 auf der Fläche 3 abgeschieden werden. Eine bevorzugte Weiterbildung dieser Ausführungsform sieht dabei insbesondere vor, daß die Schicht mittels Plasmaimpuls-induzierter chemischer Dampfphasenabscheidung (PICVD) erfolgt. Dazu kann die Beschichtungsquelle 21 beispielsweise einen Gaseinlaß für geeignete Precursor-Gase, beziehungsweise gasförmigen Edukten und eine Einrichtung zur Erzeugung von gepulsten elektromagnetischen Wellen aufweisen, mit welchen in der Precursor-Gasatmosphäre ein gepulstes Plasma erzeugt wird. Im Plasma entstehen dann Reaktionsprodukte, die sich auf der Fläche 3 anlagern und eventuell miteinander reagieren, so daß eine Schicht auf der Fläche 3 abgeschieden wird. Um eine mehrlagige optische Filterschicht 23 mit Lagen 231, 232, 233 herzustellen, kann bei der PICVD-BEschichtung die Prozeßgas-Zusammensetzung geändert werden. Beispielsweise kann eine Filterschicht mit abwechselden SiO₂- und TiO₂₋Lagen durch abwechselndes Einlassen von Titan- und Silizium-haltigen Precursor-Gasen oder Edukten erzeugt werden.

Das Vakuumabscheiden kann zumindest zeitweise bei einer Temperatur der maskierten Fläche von über 150 °C, insbesondere in einem Bereich von über 150 °C bis einschließlich 400 °C erfolgen. Gemäß einer bevorzugten Verfahrensweise liegt dabei die Temperatur der maskierten Fläche zumindest zeitweise im Bereich 170 °C ± 15 °C, bevorzugt im Bereich von 170 °C ± 10 °C. Es hat sich gezeigt, daß höhere Substrattemperaturen in mehrfacher Hinsicht vorteilhaft bei der Vakuumabscheidung sein können. So können bei der PVD-Beschichtung bei höheren Temperaturen dichtere Schichten hergestellt werden. Derartige Schichten sind dann auch stabiler und resistenter gegenüber chemischen Einflüssen. Insbesondere können solche dichteren Schichten nur wenig oder gar kein Wasser mehr aufnehmen. Die Ursache liegt in der höheren Beweglichkeit der auf die zu beschichtende Fläche auftreffenden Teilchen.

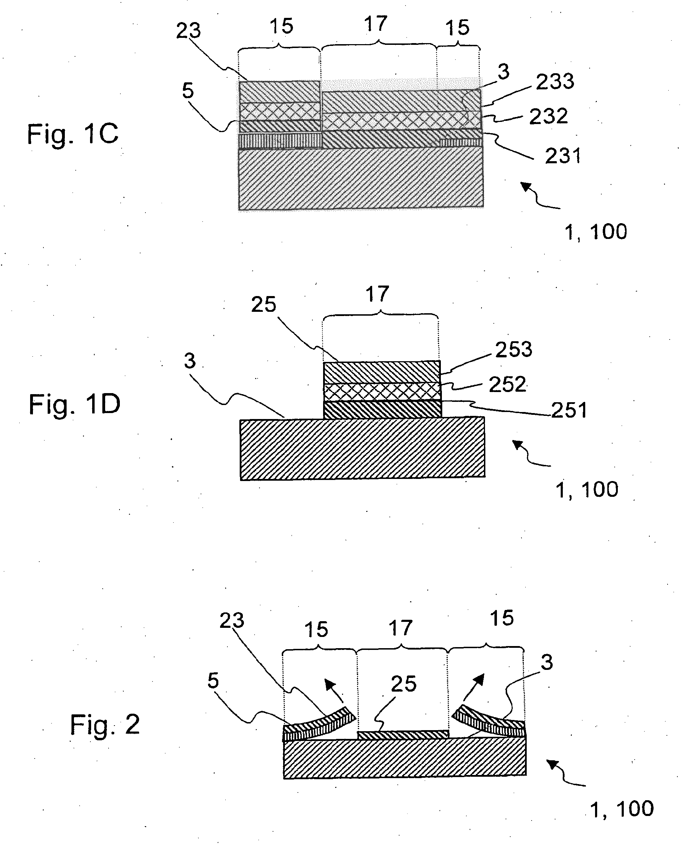

Das Entfernen der Lackschicht mit der darauf befindlichen optischen Filterschicht 23 ist in Fig. 1C dargestellt.

Der auf der rechten Seite in Fig. 1C gezeigte Teil der Lackschicht 5 befindet sich noch in dem Zustand vor dem Aufquellen, wohingegen der links in Fig. 1C gezeigte Teil der Lackschicht 5 in aufgequollenem Zustand dargestellt ist. Das Aufquellen der Lackschicht 5 kann in einfacher Weise durch eine Lauge, beispielsweise Kali- oder Natronlauge erreicht werden. Aufgrund unterschiedlicher Ausdehungskoeffizienten von Lackschicht und optischer Filterschicht können beim Abkühlen des Substrats nach dem Beschichten auch Risse in der optischen Filterschicht entstehen, durch welche ein Quellmittel, wie beispielsweise eine Lauge eindringen kann. Auf dieses Weise wird der Quellvorgang zusätzlich beschleunigt. Durch das Aufquellen der Lackschicht 5 löst sich diese von der beschichteten Fläche 3 zusammen mit den auf der Lackschicht 5 befindlichen Bereichen der optischen Filterschicht 23. Gleichzeitig bricht auch die Verbindung der Filterschicht 23 zwischen den Bereichen 15 und 17, sofern eine solche Verbindung überhaupt beim Abscheiden der Schicht 23 entstanden ist, so daß durch das Lösen der Lackschicht 5 diese dann mit der darauf befindlichen optischen Filterschicht entfernt werden kann. Für dieses Ausführungsbeispiel ist unter anderem Stoplack zur Maskierung gut geeignet, da dieser quellfähig ist und überdies eine gute Temperaturbeständigkeit und geringe Ausgasrate im Vakuum aufweist. Auch ein Photolack kann verwendet werden, was insbesondere dann in Betracht zu ziehen ist, wenn zusätzlich zu der durch Aufdrucken hergestellten Maskierung weitere Konturen durch photolithographische Strukturierung erzeugt werden sollen.

Ein Ausführungsbeispiel eines erfindungsgemäßen beschichteten Substrats als Ergebnis dieser Ausführungsform des Verfahrens ist in Fig. 1D dargestellt. Das gezeigte beschichtete Substrat 1 weist dementsprechend eine Fläche 3 auf, die mit einem optischen Filterschicht-Segment 25 mit Lagen 251, 252, 253 versehen ist. Das Filterschicht-Segment 25 bedeckt dabei den Teilbereich, beziehungsweise das Segment 17 der Fläche 3, welches nicht von der Lackschicht 5 bedeckt war.

Gemäß noch einer Ausführungsform der Erfindung wird das optische Filterschicht-Segment 25 auf dem Substrat 1 hergestellt, indem
beispielsweise wie in Fig. 1A gezeigt, eine Maskierung mit einer Lackschicht 5 auf der Fläche 3 des Substrats 1 hergestellt,
- wie etwa in Fig. 1B dargestellt, durch Vakuumabscheiden eine optische Filterschicht 23 auf der Fläche 3 abgeschieden, und
- die Lackschicht 5 mit der darauf befindlichen optischen Filterschicht allgemein durch Lift-off entfernt wird,
wobei daß das Abscheiden der optischen Filterschicht 23 in der Vakuumkammer 19 bei einer Temperatur von über 150 °C, bevorzugt in einem Bereich von über 150 °C bis einschließlich 400 °C erfolgt. Der Lift-off-Schritt, beziehungsweise das Abheben der Lackschicht mit der darauf befindlichen Filterschicht kann gemäß dieser Ausführungsform ebenfalls durch Aufquellen, wie in Fig. 1C dargestellt. Das Herstellen einer Maskierung mit einer Lackschicht 5 kann gemäß dieser Ausführungsform der Erfindung auch das photolithographische Strukturieren einer Photolackschicht umfassen. Bevorzugt erfolgt das Vakuumabscheiden der optischen Filterschicht 23 zumindest zeitweise im Bereich 170 °C ± 15 °C, besonders bevorzugt im Bereich von 170 °C ± 10 °C. Das Vakuumabscheiden erfolgt außerdem bei dieser Ausführungsform bevorzugt durch plasmaunterstütztes Abscheiden, insbesondere Sputtern oder plasmaunterstütztes Aufdampfen.

In Fig. 2 ist eine Variante der anhand von Fig. 1C erläuterten Verfahrensschritte dargestellt. Diese Ausführungsform basiert ebenfalls entsprechend beispielsweise dem anhand von Fig. 1A und 1B erläuterten Vorgehen zunächst darauf,
- eine Maskierung mit einer Lackschicht 5 auf einer Fläche 3 des Substrats 3 herzustellen und
- mit einem Vakuumabscheideverfahren eine optische Filterschicht 23 auf der Fläche 3 abzuscheiden.

Im Unterschied zu dem anhand von Fig. 1C erläuterten Entfernen der Lackschicht 5 durch Aufquellen wird hier jedoch die Lackschicht 5 samt der darauf abgeschiedenenen optischen Filterschicht 23 vom Substrat 1, beziehungsweise dessen beschichteter Fläche 3 abgezogen, so daß wiederum ein Substrat 1 mit einem einen Teilbereich 17 der Fläche 3 bedeckenden optischen Filterschicht-Segment 25 erhalten wird. Um die Lackschicht 5 abziehen zu können ist es dabei besonders zweckmäßig, einen Abziehlack für die Lackmaskierung zu verwenden. Außerdem ist die optische Filterschicht 23 beispielhaft als eine einlagige Filterschicht dargestellt. Das Verfahren ist jedoch selbstverständlich auch mit mehrlagigen Filterschichten, wie sie etwa in Fig. 1B oder 1C gezeigt ist, anwendbar.

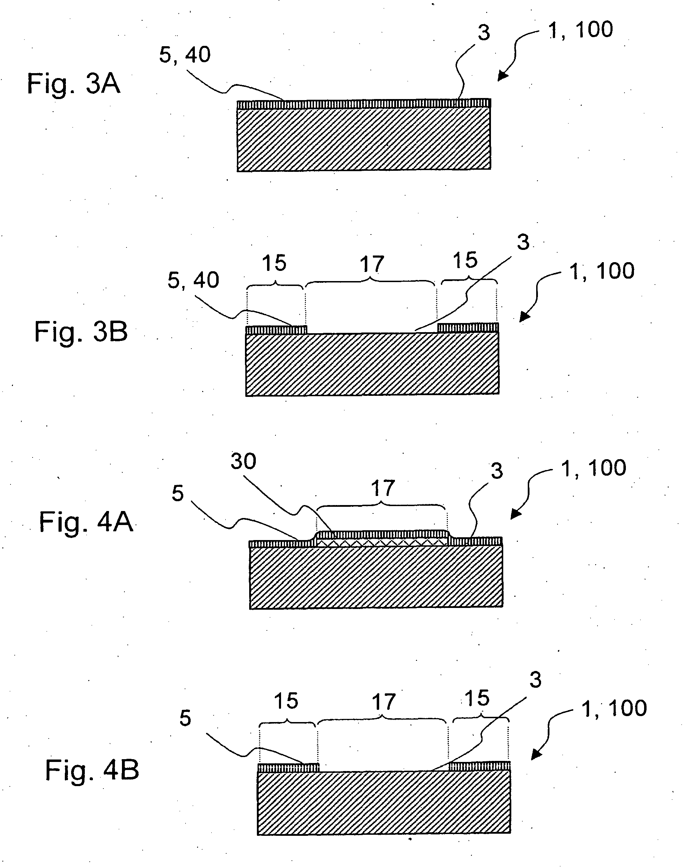

Noch ein weiteres Ausführungsbeispiel zur Maskierung der Fläche 3 zeigen die Fig. 3A und 3B. Auch hier wird beispielhaft ein scheibenförmiges Glassubstrat 100 für ein Farbrad als Substrat 1 für die Beschichtung mit einem optischen Filterschicht-Segment 25 verwendet. Die Maskierung erfolgt bei diesem Beispiel durch Beschichten mit Photolack 40 und anschließendem Belichten und Entwickeln des Photolacks. Das Beschichten erfolgt bei dem dargestellten Ausführungsbeispiel insbesondere durch einen flächigen Auftrag des Photolacks 40. Der Auftrag kann beispielsweise durch Pinseln, Rollen, Siebdruck oder Airless-Sprühen geschehen. Anschließend wird der Photolack 40 entsprechend der gewünschten Musterung der Maskierung, beziehungsweise der korrespondierenden Kontur des vorgesehenen optischen Filterschicht-Segments belichtet und entwickelt, so daß eine wie in Fig. 3B schematisch dargestellte, in ihrer flächigen Erstreckung strukturierte, beziehungsweise segmentierte Lackschicht 5 als Maskierung der Fläche 3 des Substrats 1 erhalten wird.

Anschließend kann das so maskierten Substrat wie anhand der Fig. 1B bis 1D erläutert, weiterbehandelt werden, um ein erfindungsgemäßes Substrat mit einem oder mehreren optischen Filterschicht-Segmenten zu erhalten.

Die Fig. 4A und 4B zeigen noch eine Variante zur Herstellung einer strukturierten Lackmaskierung mit einer konturierten, beziehungsweise entsprechend dem aufzubringenden optischen Filterschicht-Segment in ihrer flächigen Erstreckung strukturierten, beziehungsweise segmentierten Lackschicht 5. Gemäß dieser Variante wird, wie in Fig. 4A dargestellt ist, eine Schablone 30 auf der Fläche 3 angeordnet. Anschließend wird Lack auf die mit der Schablone versehenen Fläche aufgetragen, so daß eine Lackschicht 5 hergestellt wird, welche wenigstens die für die Maskierung vorgesehenen Teilbereiche 15 der Fläche bedeckt. Der Lack kann beispielsweise mittels Pinseln, Rollen, Siebdruck oder Airless-Sprühen aufgebracht werden.

Anschließend wird die Schablone 30 entfernt, so daß eine wie in Fig. 4B gezeigte, entsprechend der Kontur der Schablone 30 in ihrer flächigen Erstreckung strukturierten, beziehungsweise segmentierten Lackschicht 5 als Maskierung auf der Fläche 3 verbleibt. Das so maskierte Substrat 1 kann dann ebenso wie das in Fig. 3B dargestellte Substrat gemäß den Verfahrensschritten der Fig. 1B bis 1C weiterbehandelt werden.

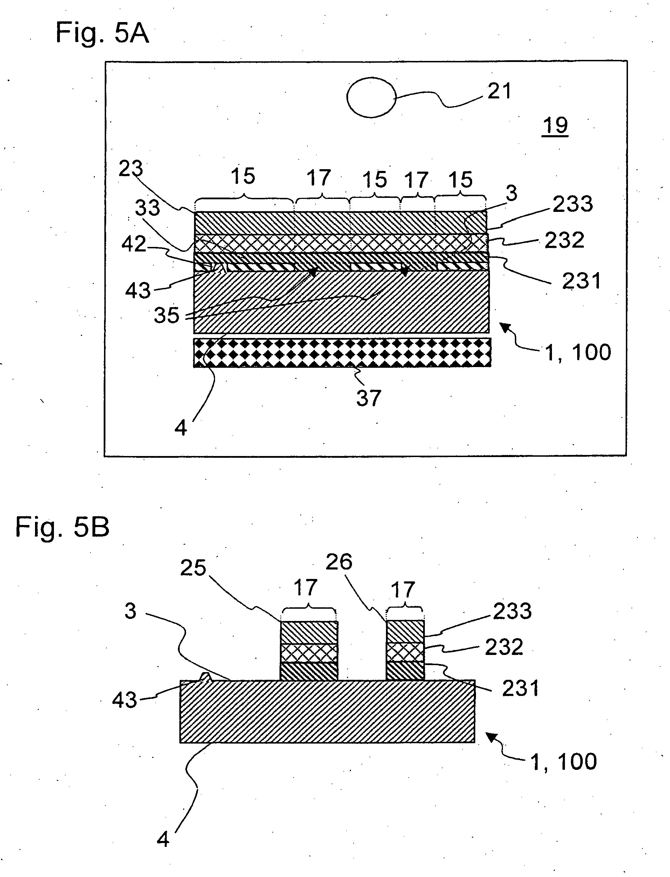

Anhand der schematischen Querschnittansichten der Fig. 5A und 5B ist eine weitere Ausführungsform des Verfahrens zur Herstellung eines optischen Filterschicht-Segments auf einem Substrat dargestellt. Bei dieser Ausführungsform der Erfindung wird
- eine Maskierung der Fläche durch Fixieren einer Konturmaske auf der Fläche des Substrats hergestellt,
- durch Vakuumabscheiden eine optische Filterschicht auf der Fläche abgeschieden, und
- die Konturmaske mit der darauf befindlichen optischen Filterschicht dann von der Fläche getrennt.

In Fig. 5A ist ein in der Vakuumkammer 19 angeordnetes Substrat 1 dargestellt, auf welchem die Konturmaske 33 mit Segmentausschnitten 35 auf der zu beschichtenden Fläche 3 des Substrats 1 fixiert ist. Die mehrlagige Filterschicht 23 mit Lagen 231; 232, 233 ist bei dem in Fig. 5A gezeigten Zustand bereits abgeschieden worden.

Insbesondere wird bei dem in Fig. 5A gezeigten Ausführungsbeispiel die Konturmaske 33 mittels magnetischer Kräfte auf der Fläche 3 gehalten. Zur Ausübung magnetischer Kräfte ist unter der Fläche 3 auf der gegenüberliegenden Seite 4 des Substrats eine Magnetanordnung 37 angeordnet. Das von der Magnetanordnung 37 erzeugte Magnetfeld bewirkt dann eine Anziehungskraft zwischen der Konturmaske 33 und der Magnetanordnung 37, welche die Konturmaske auf die Fläche 3 des Substrats zieht. Damit magnetische Kräfte auf die Konturmaske 33 ausübbar sind, ist es zweckmäßig, wenn die Konturmaske ein magnetisierbares Material umfaßt. Geeignet ist dazu beispielsweise eine Metallfolie aus magnetisierbarem Dünnblech. Eine Konturmaske mit hinreichender Genauigkeit der Konturen kann beispielsweise aus einer Folie durch Fräsen oder Laserstrahlschneiden oder Wasserstrahlschneiden oder Ätzen oder einer Kombination zumindest zweier dieser Verfahren hergestellt werden. Einige dieser Verfahren, wie beispielsweise das Fräsen gestatten es auch, einen Folienstapel zu verarbeiten, um in einem Schritt mehrere Konturmasken zu erhalten.

Um die Konturmaske möglichst exakt bezüglich der zu beschichtenden Teilbereiche 17 auszurichten, können zusätzliche Maßnahmen, wie insbesondere das Festlegen oder Justieren der Position mittels
- ein oder mehrerer Paßbohrungen oder mittels
- zumindest einer Anlagekante oder
- zumindest einer Markierung oder Klemmung oder mittels - maschineller Ausrichtung oder mittels
- zumindest einem Vorsprung auf der Fläche oder Maske oder einem nicht dargestellten Substrathalter, welcher in eine Aussparung in der Maske oder Fläche eingreift, oder mittels
- einer Kombination von zumindest zwei dieser Maßnahmen. In Fig. 5A ist ein Ausführungsbeispiel mit einem Vorsprung 43 in Form eines Zentrierdorns auf der Fläche 3 gezeigt, welcher in eine Aussparung 42 in der Maske 33 eingreift. Es ist insbesondere auch vorteilhaft, ein solches Positioniermittel, wie etwa einen oder mehrere Zentrierdorne auf dem Substrathalter anzuordnen, so daß auf dem Substrat 1 solche Mittel, wie etwa Vorsprünge nicht vorgesehen werden müssen.

Die Position des Vorsprungs 43, beziehungsweise der korrespondierenden Aussparung 42 können gemäß einer Weiterbildung dieser Ausführungsform weiterhin so gewählt werden, daß die Position der Konturmaske 33 an dem durch Vorsprung 43 und Aussparung 42 gebildeten Fixierungspunkt gegenüber der Fläche 3 fixiert wird, wobei dessen Position so gewählt ist, daß eine lokale Verschiebung der Konturen der Maske 33 aufgrund einer Temperaturänderung beim Vakuumabscheiden der optischen Filterschicht 23 minimiert ist. Damit werden eventuell auftretende unerwünschte Abweichungen der Kontur des optischen Filterschicht-Segments auf ein Minimum reduziert.

Bei dieser Ausführungsform des Verfahrens kann gemäß einer Weiterbildung die Konturmaske 33 auch erst in der Vakuumabscheidekammer 19 auf der Fläche 3 angeordnet werden. Damit kann im Vakuum der Kammer ein optisches Filterschicht-Segment hergestellt werden, ohne, daß das Substrat 1 zum Maskieren entnommen werden muß.

Nach dem Vakuumabscheiden der optischen Filterschicht 23 kann dann die Konturmaske 33 aufgrund der magnetischen Fixierung leicht zusammen mit der darauf befindlichen Filterschicht 23 entfernt werden, so daß ein wie in.Fig. 5B gezeigtes Substrat 1 mit zu den Segmentausschnitten 33 der Konturmaske 33 korrespondierenden optischen Filterschicht-Segmenten 25, 26 erhalten wird.

Gemäß einer Variante dieser Ausführungsform der Erfindung wird die Konturmaske 33 mittels einer Haftschicht auf der Fläche fixiert. Bevorzugt wird dabei die Haftschicht auf der Konturmaske aufgebracht. Das Substrat 1 wird dann, wie in Fig. 5A dargestellt, zusammen mit der durch die Haftschicht fest auf der Fläche 3 haftenden Konturmaske 33 mit einer optischen Filterschicht 23 beschichtet. Nach dem Abscheiden der optischen Filterschicht 23 kann dann die Konturmaske 33 von der Fläche abgezogen werden. Um etwaige vorhandene Klebstoffreste von der Fläche 3 zu entfernen, kann das Subtrat -bevorzugt durch Waschen- anschließend gereinigt werden.

Als Konturmaske 33 ist für diese Variante beispielsweise eine Kunststofffolie aus temperaturbeständigem Kunstoff geeignet. Insbesondere kann dazu eine Polyimid-Folie verwendet werden, die besonders temperaturstabil ist.

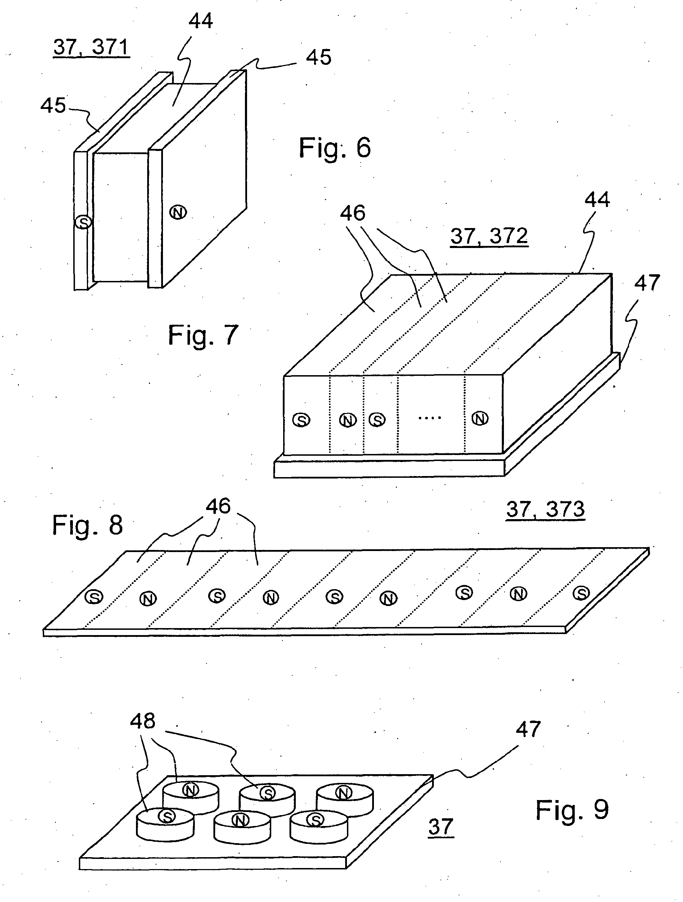

In den Fig. 6 bis 9 sind verschiedene Ausführungsbeispiele für eine Magnetanordnung 37 dargestellt, wie sie für die magnetische Fixierung der Konturmaske eingesetzt werden kann.

Fig. 6 zeigt eine Magnetanordnung 37, die eine Polschuhanordnung 371 mit einem Magnetkörper 44 und Polschuhen 45 umfaßt. Eine derartige Magnetanordnung 37 ist beispielsweise für kleinere Konturmasken geeignet. Es können aber zum Beispiel auch mehrere solcher Polschuhanordnungen 371 verwendet werden, um die Konturmaske 33 an mehreren Bereichen festzuhalten.

In Fig. 7 ist ein Ausführungsbeispiel einer Magnetanordnung 37 mit einer Feinpolanordnung 372 gezeigt. Die Feinpolanordnung 372 umfaßt einen Magnetkörper 44 mit Polen 46, welcher auf einer Rückschlußplatte 47 befestigt ist. Die Feinpolanordnung 371 wird bevorzugt so auf oder über der Seite 4 des zu beschichtenden Substrats angeordnet, welche der zu beschichtenden Fläche 3 gegenüberliegt , daß die Rückschlußplatte 47 vom Substrat wegzeiat.

Bei dem in Fig. 8 dargestellten Ausführungsbeispiel umfaßt die Magnetanordnung 37 ein Magnetband 373 mit Polen 46. Ein solches Magnetband bietet beispielsweise den Vorteil, daß es flexibel sein kann und sich daher der Form des Substrats 1 im Rahmen seiner Verformbarkeit anpassen kann.

Noch eine weitere Möglichkeit für eine Magnetanordnung 37 ist in Fig. 9 dargestellt. Diese Magnetanordnung 37 umfaßt mehrere Einzelmagnete 48, die auf einer Rückschlußplatte 47 angeordnet sind, um eine hinreichend homogene Verteilung der auf die Konturmaske 33 wirkenden magnetischen Kräfte zu erreichen. Beispielsweise können bei dieser Anordnung dazu auch, wie in Fig. 9 dargestellt, abwechselnd Nord- und Südpole nach außen weisen. Auch diese Anordnung wird vorzugsweise so am Substrat 1 angeordnet, daß die Rückschlußplatte 47 vom Substrat wegzeigt, beziehungsweise so, daß die Pole der Einzelmagneten auf die Seite 4 zeigen.

Mit diesen Beispielen von Magnetanordnungen, wie sie die Fig. 5 bis 9 zeigen, kann eine weitgehend homogene Verteilung der Anziehungskräfte über die Maskenfläche erzielt werden, um eine gute Anlage der Konturmaske über die zu beschichtende Fläche hinweg zu erreichen. Hierdurch wird ein Unterkriechen des Schichtmaterials der optischen Filterschicht unter die Konturmaske verhindert und gleichzeitig eine Konturschärfe des optischen Filterschicht-Segments erreicht, die mit der Konturschärfe der Maske vergleichbar ist.

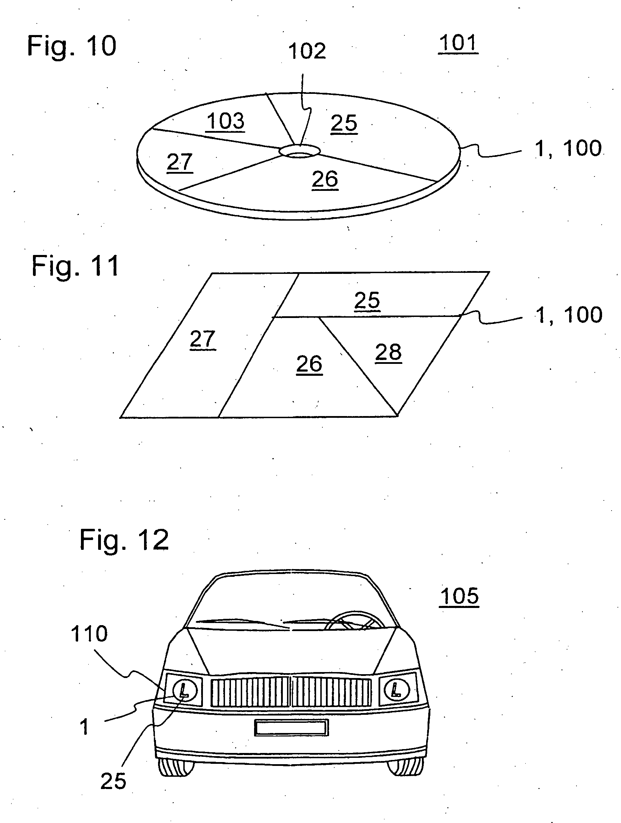

Die Fig. 10 bis 12 zeigen Ausführungsbeispiele erfindungsgemäß beschichteter Substrate. In Fig. 10 ist eine Filterscheibe 101 für ein Farbrad, wie es in digitalen Projektoren eingesetzt wird, dargestellt. Die Filterscheibe 101 umfasst ein scheibenförmiges Glassubstrat, wie es in Querschnittansicht auch in den Fig. 1A bis 1D, Fig. 2, Fig. 3A, 3B, 4A, 4B, 5A, 5B gezeigt ist. Das Glassubstrat 100 ist kreisförmig und weist eine zentral angeordnete Öffnung 102 auf. Diese Öffnung dient beispielsweise zur Befestigung und Zentrierung der Filterscheibe 101 auf einer Unterlage. Das Substrat 1, beziehungsweise 100 ist mit drei erfindungsgemäß hergestellten kreissegmentförmigen optischen Filterschicht-Segmenten 25, 26, 27 beschichtet. Die Filterschicht-Segmente 25, 26, 27 sind bevorzugt als mehrlagige Interferenz-Filterschichten abgeschieden, um jeweils bestimmte Farben einer Lichtquelle, in deren Strahlengang das Farbrad angeordnet ist, auszufiltern. Entsprechend den drei verschiedenen optischen Filterschicht-Segmenten werden die Schritte des Maskierens und des Vakuumabscheidens für jedes Segment 25, 26, 27 wiederholt, wobei durch unterschiedliche Maskierung die vorgesehenen unterschiedlichen Segmente der Fläche des Substrats mit jeweils anderen optischen Filterschichten versehen werden.

Das Farbrad mit der Filterscheibe rotiert dabei, so daß die Farben sequentiell ausgefiltert werden. Ein weiteres Kreissegment 103 ist unbeschichtet, um einen zusätzlichen Weiß- oder Helligkeitskanal bereitzustellen. Die einzelnen Segmente müssen insbesondere auch nicht gleich groß sein. Vielmehr kann die Größe der von den Filterschicht-Segmenten 25, 26, 27 bedeckten Sektoren von der spektralen Verteilung der verwendeten Lichtquelle abhängig sein, um eine ausgewogene Farbverteilung bei guter Lichtausbeute zu erreichen.

Das erfindungsgemäße Verfahren eignet sich aber auch zur Beschichtung eine Vielzahl weiterer Substrate. Fig. 11 zeigt beispielsweise eine mit mehreren optischen Filterschicht-Segmenten 25, 26, 27, 28 beschichtete Folie 104. Auch eine solche Folie kann als segmentierter optischer Filter verwendet werden. Die Filterschicht-Segmente können aber auch beispielsweise zur Dekoration dienen. Ein solches Substrat kann auch für einen Sensor mit mehreren jeweils einem optischen Filterschicht-Segment zugeordneten Sensorflächen verwendet werden, um auf die Sensorflächen auftreffendes Licht zu filtern. So können jeweils verschiedene Farben mit den Segmenten ausgefiltert und detektiert werden. Ebenso kann ein Sensor selbst als Substrat für eine Beschichtung einer oder mehrerer seiner Sensorflächen verwendet werden. Eine Anwendung der Erfindung ist beispielsweise eine Beschichtung der Pixelbereiche eines Bildsensors zur Farbfilterung.

Mit der Erfindung können außerdem auch optische Filterschicht-Segmente abgeschieden werden, die in Form einer sichtbaren Information, insbesondere eines Schriftzugs, Symbols oder Logos geformt sind. Ein solches Beispiel ist in Fig. 12 dargestellt. Fig. 12 zeigt die Frontansicht eines Kraftfahrzeugs 105 mit Scheinwerfern 110. In die Scheinwerfer 110 des Kraftfahrzeugs 105 sind jeweils erfindungsgemäß beschichtete Substrate 1 eingesetzt. Die optischen Filterschicht-Segmente 25 auf den eingesetzten, vorzugsweise transparenten Substraten sind insbesondere in Form einer sichtbaren Information gemustert. Insbesondere kann bei diesem Ausführungsbeispiel die Beschichtung in Form eines Logos gemustert sein, wobei das durch die Beschichtung 25 gebildete Logo in Fig. 12 lediglich beispielhaft in Form eines kursiven "L" symbolisiert ist. Beispielsweise können die Beschichtungen 25 in Form des Logos oder Schriftzugs des Herstellers des Kraftfahrzeugs durch eine Strukturierung in ihrer flächigen Erstreckung, insbesondere einer Segmentierung gemustert sein. Dieses Logo ist dann bei ausgeschaltetem Scheinwerfer oder bei leichter Beleuchtung, etwa bei Einschaltung des Standlichts sichtbar und ergibt einen reizvollen dekorativen Effekt.

Es ist dem Fachmann ersichtlich, dass die Erfindung nicht auf die vorstehend beschriebenen beispielhaften Ausführungsformen beschränkt ist, sondern vielmehr in vielfältiger Weise variiert werden kann. Insbesondere können die Merkmale der einzelnen Ausführungsbeispiele auch miteinander kombiniert werden.

### Bezugszeichenliste

- 1: Substrat
- 3: Fläche von 1
- 4: zu 3 gegenüberliegende Seite von 1
- 5: Lackschicht
- 7: Druckkopf
- 9: Düse von 7
- 11: Tank von 7
- 13: Lack
- 15: maskiertes Segment von 3
- 17: freies, nicht maskiertes Segment von 3
- 19: Vakuumkammer
- 21: Beschichtungsquelle
- 23: optische Filterschicht
- 231, 232, 233: Lagen von 23
- 25, 26, 27, 28: optisches Filterschicht-Segment
- 251, 252, 253: Lagen von 25
- 30: Schablone
- 33: Konturmaske
- 35: Segmentausschnitt von 33
- 37: Magnetanordnung
- 371: Polschuhanordnung
- 372: Feinpolanordnung
- 373: Magnetband
- 40: Photolack
- 42: Vorsprung
- 43: Aussparung
- 44: Magnetkörper
- 45: Polschuh
- 46: Pole von 44
- 47: Rückschlußplatte
- 48: Einzelmagnet
- 100: Glassubstrat für ein Farbrad
- 101: Filterscheibe für ein Farbrad
- 102: Öffnung in 101
- 103: unbeschichtetes Kreissegment von 100
- 104: Folie
- 105: Kraftfahrzeug
- 110: Scheinwerfer

## Patentansprüche

1. Verfahren zur Herstellung zumindest eines optischen Filterschicht-Segments auf einem Substrat, bei welchem
- eine Maskierung mit einer Lackschicht auf einer Fläche des Substrats hergestellt, so dass Teilbereiche der Fläche frei bleiben,
- durch Vakuumabscheiden eine optische Filterschicht auf der Lackschicht und den frei gebliebenen Teilbereichen der Fläche abgeschieden, und
- die Lackschicht mit der darauf befindlichen optischen Filterschicht von der Fläche entfernt wird, wobei die optische Filterschicht auf den frei gebliebenen Teilbereichen der Fläche verbleibt, wobei die Lackschicht mit der darauf befindlichen optischen Filterschicht durch Aufquellen der Lackschicht entfernt wird und wobei das Entfernen der Lackschicht durch Aufquellen das Behandeln der Lackschicht mit einer Lauge umfasst,
wobei das Abscheiden der optischen Filterschicht zumindest zeitweise bei einer Temperatur von über 150 °C, bevorzugt in einem Bereich von über 150 °C bis einschließlich 400 °C erfolgt.

2. Verfahren gemäß Anspruch 1, **dadurch gekennzeichnet, daß** das Vakuumabscheiden der optischen Filterschicht zumindest zeitweise im Bereich 170 °C ± 15 °C, bevorzugt im Bereich von 170 °C ± 10 °C erfolgt.

3. Verfahren gemäß Anspruch 1 oder 2, **dadurch gekennzeichnet, daß** das Vakuumabscheiden das plasmaunterstützte Abscheiden, insbesondere Sputtern oder plasmaunterstütztes Aufdampfen umfaßt.

4. Verfahren gemäß Anspruch 1, **dadurch gekennzeichnet, daß** das Herstellen der Maskierung mit einer Lackschicht das Aufbringen eines Stoplacks umfaßt.

5. Verfahren zur Herstellung eines optischen Filterschicht-Segments auf einem Substrat, gemäß einem der vorstehenden Ansprüche, bei welchem
- die Lackschicht samt der darauf befindlichen optischen Filterschicht vom Substrat abgezogen wird.

6. Verfahren gemäß einem der vorstehenden Ansprüche, **dadurch gekennzeichnet, daß** Lack für die Lackschicht aufgedruckt wird.

7. Verfahren gemäß Anspruch 6, **dadurch gekennzeichnet, daß** Lack für die Lackschicht mittels eines Druckkopfs aufgedruckt wird.

8. Verfahren gemäß einem der vorstehenden Ansprüche, **dadurch gekennzeichnet, daß** Lack für die Lackschicht durch rechnergesteuertes Aufdrucken auf das Substrat aufgebracht wird.

9. Verfahren gemäß einem der vorstehenden Ansprüche, **dadurch gekennzeichnet, daß** eine Schablone auf der Fläche angeordnet und Lack auf die mit der Schablone versehene Fläche aufgetragen wird.

10. Verfahren gemäß einem der vorstehenden Ansprüche, **dadurch gekennzeichnet, daß** Lack für die Lackschicht mittels Pinseln, Rollen, Siebdruck oder Airless-Sprühen aufgebracht wird.

11. Verfahren gemäß einem der vorstehenden Ansprüche, bei welchem die beschichtete Fläche beim Abscheiden erwärmt ist und die auf der Lackschicht abgeschiedene optische Filterschicht beim Abkühlen Risse erhält.

12. Verfahren zur Herstellung eines optischen Filterschicht-Segments auf einem Substrat, gemäß einem der vorstehenden Ansprüche, bei welchem
- eine Maskierung der Fläche durch Fixieren einer Konturmaske auf der Fläche des Substrats hergestellt wird,
- durch Vakuumabscheiden eine optische Filterschicht auf der Fläche abgeschieden, und
- die Konturmaske mit der darauf befindlichen optischen Filterschicht von der Fläche getrennt wird.

13. Verfahren gemäß Anspruch 12, **dadurch gekennzeichnet, daß** die Konturmaske in der Vakuumabscheidekammer auf der Fläche angeordnet wird.

14. Verfahren gemäß Anspruch 12 oder 13, **dadurch gekennzeichnet, daß** die Konturmaske mittels magnetischer Kräfte auf der Fläche gehalten wird.

15. Verfahren gemäß Anspruch 14, **dadurch gekennzeichnet, daß** die Konturmaske mit einer unter der Fläche angeordneten Magnetanordnung fixiert wird.

16. Verfahren gemäß Anspruch 15, **dadurch gekennzeichnet, daß** die Magnetanordnung eine Polschuhanordnung, eine Feinpolanordnung, ein Magnetband oder einzelne Magnete auf einer Rückschlußplatte umfaßt.

17. Verfahren gemäß einem der Ansprüche 12 bis 16, **dadurch gekennzeichnet, daß** die Konturmaske ein magnetisierbares Material umfaßt.

18. Verfahren gemäß einem der Ansprüche 12 bis 17, **dadurch gekennzeichnet, daß** die Konturmaske eine-Metallfolie oder eine Kunststofffolie, insbesondere mit einem temperaturbeständigen Kunstoff umfaßt.

19. Verfahren gemäß einem der Ansprüche 12 bis 18, **dadurch gekennzeichnet, daß** die Konturmaske mittels einer Haftschicht auf der Fläche fixiert wird.

20. Verfahren gemäß Anspruch 19, **dadurch gekennzeichnet, daß** die Konturmaske nach dem Abscheiden von der Fläche abgezogen wird.

21. Verfahren gemäß einem der Ansprüche 12 bis 20, **dadurch gekennzeichnet, daß** die Position der Konturmaske mittels
- ein oder mehrerer Paßbohrungen oder mittels
- zumindest einer Anlagekante oder
- zumindest einer Markierung oder Klemmung oder mittels - maschineller Ausrichtung oder mittels
- zumindest einem Vorsprung auf der Fläche oder Maske, welcher in eine Aussparung in der Maske oder Fläche eingreift, oder mittels
- einer Kombination von zumindest zwei dieser Maßnahmen festgelegt oder justiert wird.

22. Verfahren gemäß einem der Ansprüche 12 bis 21, **dadurch gekennzeichnet, daß** die Position der Konturmaske an einem Fixierungspunkt gegenüber der Fläche fixiert wird, dessen Position so gewählt ist, daß eine lokale Verschiebung der Konturen der Maske aufgrund einer Temperaturänderung beim Vakuumabscheiden der optischen Schicht minimiert ist.

23. Verfahren gemäß einem der Ansprüche 12 bis 22, **dadurch gekennzeichnet, daß** die Konturmaske aus einer Folie durch Stanzen oder Fräsen oder Laserstrahlschneiden oder Wasserstrahlschneiden oder Ätzen oder einer Kombination zumindest zweier dieser Verfahren hergestellt wird.

24. Verfahren gemäß einem der vorstehenden Ansprüche, **dadurch gekennzeichnet, daß** das Vakuumabscheiden der optischen Filterschicht die physikalische Dampfphasenabscheidung (PVD) zumindest einer Schicht umfaßt.

25. Verfahren gemäß einem der vorstehenden Ansprüche, **dadurch gekennzeichnet, daß** das Vakuumabscheiden der optischen Filterschicht das Aufsputtern zumindest einer Schicht umfaßt.

26. Verfahren gemäß einem der vorstehenden Ansprüche, **dadurch gekennzeichnet, daß** das Vakuumabscheiden der optischen Filterschicht das Aufdampfen zumindest einer Schicht umfaßt.

27. Verfahren gemäß einem der vorstehenden Ansprüche, **dadurch gekennzeichnet, daß** das Vakuumabscheiden der optischen Filterschicht die chemische Dampfphasenabscheidung zumindest einer Schicht umfaßt.

28. Verfahren gemäß einem der vorstehenden Ansprüche, **dadurch gekennzeichnet, daß** das Vakuumabscheiden der optischen Filterschicht das plasmaimpuls-induzierte Dampfphasenabscheiden zumindest einer Schicht umfaßt.

29. Verfahren gemäß einem der vorstehenden Ansprüche, **dadurch gekennzeichnet, daß** das Vakuumabscheiden der optischen Filterschicht das Abscheiden einer mehrlagigen Schicht umfaßt.

30. Verfahren gemäß Anspruch 29, **dadurch gekennzeichnet, daß** zumindest zwei Lagen mit unterschiedlicher Zusammensetzung abgeschieden werden.

31. Verfahren gemäß einem der vorstehenden Ansprüche, **dadurch gekennzeichnet, daß** das Vakuumabscheiden der optischen Filterschicht das Abscheiden einer Interferenz-Filterschicht umfaßt.

32. Verfahren gemäß einem der vorstehenden Ansprüche, **dadurch gekennzeichnet, daß** das Vakuumabscheiden der optischen Filterschicht zumindest zeitweise bei einer Temperatur der maskierten Fläche von über 150 °C, bevorzugt in einem Bereich von über 150 °C bis einschließlich 400 °C erfolgt.

33. Verfahren gemäß Anspruch 32, **dadurch gekennzeichnet, daß** die Temperatur der maskierten Fläche zumindest zeitweise im Bereich 170 °C ± 15 °C, bevorzugt im Bereich von 170 °C ± 10 °C liegt.

34. Verfahren gemäß einem der vorstehenden Ansprüche, **dadurch gekennzeichnet, daß** ein kreissegmentförmiges Segment der Fläche beschichtet wird.

35. Verfahren gemäß einem der vorstehenden Ansprüche, **dadurch gekennzeichnet, daß** ein optisches Filterschicht-Segment abgeschieden wird, welches in Form einer sichtbaren Information, insbesondere eines Schriftzugs, Symbols oder Logos geformt ist.

36. Verfahren gemäß einem der vorstehenden Ansprüche, **dadurch gekennzeichnet, daß** die Schritte des Maskierens und des Vakuumabscheidens zumindest einmal wiederholt werden, wobei durch unterschiedliche Maskierung unterschiedliche Segmente der Fläche mit einer optischen Filterschicht versehen werden.

37. Verfahren gemäß Anspruch 36, **dadurch gekennzeichnet, daß** die unterschiedlichen Segmente mit unterschiedlichen optischen Filterschichten versehen werden.

38. Verfahren gemäß einem der vorstehenden Ansprüche, **dadurch gekennzeichnet, daß** ein scheibenförmiges Substrat für ein Farbrad beschichtet wird.

39. Verfahren gemäß einem der vorstehenden Ansprüche, **dadurch gekennzeichnet, daß** ein Glassubstrat oder eine Glasfläche eines Substrats beschichtet wird.

40. Verwendung eines Verfahrens gemäß einem der vorstehendem Ansprüche zur Herstellung eines segmentierten optischen Filters.

41. Verwendung eines Verfahrens gemäß einem der vorstehenden Ansprüche zur Herstellung eines Sensors mit Sensorflächen, von denen zumindest eine von einem optischen Filterschicht-Segment bedeckt ist.

42. Verwendung eines Verfahrens gemäß einem der vorstehenden Ansprüche zur Beschichtung von Folien.

43. Verwendung eines Verfahrens gemäß einem der vorstehenden Ansprüche zur Beschichtung von Unterlagen mit dekorativen Mustern.

## Claims

1. A method for producing at least one optical filter layer segment on a substrate, comprising
- preparing a resist layer masking on a surface of the substrate so that portions of the surface remain free;
- depositing an optical filter layer on the resist layer and on the portions of the surface that remained free, by vacuum deposition; and
- removing the resist layer with the optical filter layer thereon from the surface, while on the portions of the surface that remained free the optical filter layer remains, wherein the resist layer with the optical filter layer thereon is removed by causing the resist layer to swell, and wherein the removing of the resist layer by causing it to swell comprises treating the resist layer with an alkaline solution;
wherein the deposition of the optical filter layer is performed at a temperature above 150 °C, preferably in a range from more than 150 °C up to 400 °C, at least temporarily.

2. The method according to claim 1, **characterized in that** the vacuum deposition of the optical filter layer is performed in a range of 170 °C ± 15 °C, preferably in a range of 170 °C ± 10 °C, at least temporarily.

3. The method according to claim 1 or 2, **characterized in that** the vacuum deposition comprises plasma-assisted deposition, in particular sputter deposition or plasma-assisted vapour deposition.

4. The method according to claim 1, **characterized in that** the preparing of the resist layer masking comprises applying a stop resist.

5. The method of manufacturing an optical filter layer segment on a substrate according to any of the preceding claims, wherein
- the resist layer is peeled off from the substrate together with the optical filter layer thereon.

6. The method according to any of the preceding claims, **characterized in that** the resist for the resist layer is printed.

7. The method according to claim 6, **characterized in that** the resist for the resist layer is printed using a printing head.

8. The method according to any of the preceding claims, **characterized in that** the resist for the resist layer is applied to the substrate by computer-controlled printing.

9. The method according to any of the preceding claims, **characterized in that** a template is arranged on the surface and the resist is applied to the surface provided with the template.

10. The method according to any of the preceding claims, **characterized in that** the resist for the resist layer is applied by brushing, rolling, screen printing, or airless spraying.

11. The method according to any of the preceding claims, wherein the coated surface is heated during deposition and the optical filter layer deposited on the resist layer forms cracks as it is cooling.

12. The method for producing an optical filter layer segment on a substrate according to any of the preceding claims, wherein
- a masking of the surface is prepared by fixing a contour mask on the surface of the substrate;
- an optical filter layer is deposited on the surface by vacuum deposition; and
- the contour mask with the optical filter layer thereon is removed from the surface.

13. The method according to claim 12, **characterized in that** the contour mask is arranged on the surface in the vacuum deposition chamber.

14. The method according to claim 12 or 13, **characterized in that** the contour mask is held on the surface by magnetic forces.

15. The method according to claim 14, **characterized in that** the contour mask is fixed using a magnet arrangement arranged below the surface.

16. The method according to claim 15, **characterized in that** the magnet arrangement comprises a pole shoe arrangement, a fine pole arrangement, a magnetic tape, or individual magnets on a return plate.

17. The method according to any of claims 12 to 16, **characterized in that** the contour mask comprises a magnetizable material.

18. The method according to any of claims 12 to 17, **characterized in that** the contour mask comprises a metal foil or a plastic film, in particular one that includes a heat-resistant plastic.

19. The method according to any of claims 12 to 18, **characterized in that** the contour mask is fixed on the surface by means of an adhesive layer.

20. The method according to claim 19, **characterized in that** after the deposition the contour mask is peeled off from the surface.

21. The method according to any of claims 12 to 20, **characterized in that** the position of the contour mask is defined or adjusted by means of
- one or more aligning holes; or by means of
- at least one abutment edge; or
- at least one mark or clamp; or by means of
- machine alignment; or by means of
- at least one projection on the surface or on the mask, which engages in a recess in the mask or the surface; or by
- any combination of at least two of said measures.

22. The method according to any of claims 12 to 21, **characterized in that** the position of the contour mask is fixed with respect to the surface at a fixing point whose position is selected so as to minimize a local shift of the contours of the mask due to a temperature change during the vacuum deposition of the optical layer.

23. The method according to any of claims 12 to 22, **characterized in that** the contour mask is prepared from a foil by punching or milling or laser beam cutting or water jet cutting or etching or a combination of at least two of said processes.

24. The method according to any of the preceding claims, **characterized in that** the vacuum deposition of the optical filter layer comprises physical vapour deposition (PVD) of at least one layer.

25. The method according to any of the preceding claims, **characterized in that** the vacuum deposition of the optical filter layer comprises sputter-deposition of at least one layer.

26. The method according to any of the preceding claims, **characterized in that** the vacuum deposition of the optical filter layer comprises vapour deposition of at least one layer.

27. The method according to any of the preceding claims, **characterized in that** the vacuum deposition of the optical filter layer comprises chemical vapour deposition of at least one layer.

28. The method according to any of the preceding claims, **characterized in that** the vacuum deposition of the optical filter layer comprises plasma pulse induced vapour deposition of at least one layer.

29. The method according to any of the preceding claims, **characterized in that** the vacuum deposition of the optical filter layer comprises depositing a multilayered coating.

30. The method according to claim 29, **characterized in that** at least two layers of different composition are deposited.

31. The method according to any of the preceding claims, **characterized in that** the vacuum deposition of the optical filter layer comprises depositing an interference filter layer.

32. The method according to any of the preceding claims, **characterized in that** the vacuum deposition of the optical filter layer is performed at a temperature of the masked surface above 150 °C, preferably in a range from more than 150 °C up to 400 °C, at least temporarily.

33. The method according to claim 32, **characterized in that** the temperature of the masked surface is in a range of 170 °C ± 15 °C, preferably in a range of 170 °C ± 10 °C, at least temporarily.

34. The method according to any of the preceding claims, **characterized in that** the surface segment coated has a shape of a circle segment.

35. The method according to any of the preceding claims, **characterized in that** the optical filter layer segment deposited has a shape in form of visible information, especially of an inscription, a symbol, or a logo.

36. The method according to any of the preceding claims, **characterized in that** the steps of masking and vacuum deposition are repeated at least once, wherein by different masking different segments of the surface are provided with an optical filter layer.

37. The method according to claim 36, **characterized in that** the different segments are provided with different optical filter layers.

38. The method according to any of the preceding claims, **characterized in that** a disk-like substrate for a colour wheel is coated.

39. The method according to any of the preceding claims, **characterized in that** a glass substrate or a glass surface of a substrate is coated.

40. Use of a method according to any of the preceding claims for producing a segmented optical filter.

41. Use of a method according to any of the preceding claims for producing a sensor having sensor surfaces of which at least one is covered with an optical filter layer segment.

42. Use of a method according to any of the preceding claims for coating foils or films.

43. Use of a method according to any of the preceding claims for coating substrates with decorative patterns.

## Revendications

1. Procédé pour la réalisation d'au moins un segment de couche filtrante optique sur un substrat, dans lequel :
- un masquage avec une couche de vernis est réalisé sur une surface du substrat de manière à lasser libres des zones partielles de la surface,
- une couche filtrante optique est déposée, par dépôt sous vide, sur la couche de vernis et les zones partielles restées libres de la surface, et
- la couche de vernis avec la couche filtrante optique située sur celle-ci est enlevée de la surface, la couche filtrante optique subsistant sur les zones partielles dégagées de la surface, la couche de vernis avec la couche filtrante optique située sur celle-ci étant enlevée sous l'effet du gonflement de ladite couche de vernis, et l'enlèvement de la couche de vernis sous l'effet du gonflement consiste à traiter la couche de vernis avec une lessive alcaline, le dépôt de la couche filtrante optique étant effectué au moins temporairement à une température supérieure à 150°C, de préférence dans une plage supérieure à 150°C jusqu'à 400°C inclus.

2. Procédé selon la revendication 1, **caractérisé en ce que** le dépôt sous vide de la couche filtrante optique est effectué au moins temporairement dans une plage de 170°C ± 15°C, de préférence dans une plage de 170°C ± 10°C.

3. Procédé selon la revendication 1 ou 2, **caractérisé en ce que** le dépôt sous vide comporte le dépôt assisté par plasma, en particulier la pulvérisation cathodique ou la métallisation sous vide assistée par plasma.

4. Procédé selon la revendication 1, **caractérisé en ce que** la réalisation du masquage avec une couche de vernis comporte l'application d'une réserve de soudure.

5. Procédé pour la réalisation d'un segment de couche filtrante optique sur un substrat selon l'une des revendications précédentes, dans lequel
- la couche de vernis, y compris la couche filtrante optique située sur celle-ci, est enlevée du substrat.

6. Procédé selon l'une quelconque des revendications précédentes, **caractérisé en ce que** le vernis pour la couche de vernis est appliqué par impression.

7. Procédé selon la revendication 6, **caractérisé en ce que** le vernis pour la couche de vernis est imprimé au moyen d'une tête d'impression.

8. Procédé selon l'une quelconque des revendications précédentes, **caractérisé en ce que** le vernis pour la couche de vernis est appliqué sur le substrat au moyen d'une impression commandée par ordinateur.

9. Procédé selon l'une quelconque des revendications précédentes, **caractérisé en ce qu'**un gabarit est disposé sur la surface et le vernis est appliqué sur la surface munie du gabarit.

10. Procédé selon l'une quelconque des revendications précédentes, **caractérisé en ce que** le vernis pour la couche de vernis est appliqué au pinceau, au rouleau, par sérigraphie ou par pulvérisation sans air comprimé.

11. Procédé selon l'une quelconque des revendications précédentes, dans lequel la surface revêtue est chauffée lors du dépôt et la couche filtrante optique déposée sur la couche de vernis se fissure pendant le refroidissement.

12. Procédé pour la réalisation d'un segment de couche filtrante optique sur un substrat selon l'une des revendications précédentes, dans lequel
- un masquage de la surface est réalisé par la fixation d'un masque de contour sur la surface du substrat,
- une couche filtrante optique est déposée, par dépôt sous vide, sur la surface, et
- le masque de contour avec la couche filtrante optique située sur celui-ci est séparé de la surface.

13. Procédé selon la revendication 12, **caractérisé en ce que** le masque de contour est agencé sur la surface dans la chambre de dépôt sous vide.

14. Procédé selon la revendication 12 ou 13, **caractérisé en ce que** le masque de contour est maintenu sur la surface au moyen de forces magnétiques.

15. Procédé selon la revendication 14, **caractérisé en ce que** le masque de contour est fixé au moyen d'un système d'aimants disposé en dessous de la surface.

16. Procédé selon la revendication 15, **caractérisé en ce que** le système d'aimants comporte un système d'épanouissement polaire, un système micropolaire, une bande magnétique ou différents aimants sur une plaque de dérivation.

17. Procédé selon l'une quelconque des revendications 12 à 16, **caractérisé en ce que** le masque de contour comporte un matériau magnétisable.

18. Procédé selon l'une quelconque des revendications 12 à 17, **caractérisé en ce que** le masque de contour comporte une feuille métallique ou une feuille plastique, en particulier avec une matière plastique résistant à la température.

19. Procédé selon l'une quelconque des revendications 12 à 18, **caractérisé en ce que** le masque de contour est fixé sur la surface au moyen d'une couche adhésive.

20. Procédé selon la revendication 19, **caractérisé en ce que** le masque de contour est enlevé de la surface après le dépôt.

21. Procédé selon l'une quelconque des revendications 12 à 20, **caractérisé en ce que** la position du masque de contour est définie ou ajustée au moyen
- d'une ou de plusieurs forures d'ajustage, ou au moyen
- d'au moins un bord d'appui ou
- d'au moins un marquage ou serrage, ou au moyen
- d'un ajustement mécanique, ou au moyen
- d'au moins une saillie sur la surface ou le masque, laquelle s'engage dans un évidement dans le masque ou la surface, ou au moyen
- d'une combinaison d'au moins deux de ces mesures.

22. Procédé selon l'une quelconque des revendications 12 à 21, **caractérisé en ce que** la position du masque de contour est fixée par rapport à la surface en un point de fixation, dont la position est choisie de manière à minimiser le déplacement local des contours du masque sous l'effet d'une variation de température pendant le dépôt sous vide de la couche optique.

23. Procédé selon l'une quelconque des revendications 12 à 22, **caractérisé en ce que** le masque de contour est réalisé dans une feuille par découpe ou fraisage ou par découpe par rayon laser ou par découpe au jet d'eau ou par gravure ou par une combinaison d'au moins deux de ces procédés.

24. Procédé selon l'une quelconque des revendications précédentes, **caractérisé en ce que** le dépôt sous vide de la couche filtrante optique comporte le dépôt physique en phase vapeur (PVD) d'au moins une couche.

25. Procédé selon l'une quelconque des revendications précédentes, **caractérisé en ce que** le dépôt sous vide de la couche filtrante optique comporte la pulvérisation cathodique d'au moins une couche.

26. Procédé selon l'une quelconque des revendications précédentes, **caractérisé en ce que** le dépôt sous vide de la couche filtrante optique comporte la métallisation sous vide d'au moins une couche.

27. Procédé selon l'une quelconque des revendications précédentes, **caractérisé en ce que** le dépôt sous vide de la couche filtrante optique comporte le dépôt chimique en phase vapeur d'au moins une couche.

28. Procédé selon l'une quelconque des revendications précédentes, **caractérisé en ce que** le dépôt sous vide de la couche filtrante optique comporte le dépôt en phase vapeur induit par impulsion plasma d'au moins une couche.

29. Procédé selon l'une quelconque des revendications précédentes, **caractérisé en ce que** le dépôt sous vide de la couche filtrante optique comporte le dépôt d'une couche en plusieurs strates.

30. Procédé selon la revendication 29, **caractérisé en ce qu'**au moins deux strates de composition différente sont déposées.

31. Procédé selon l'une quelconque des revendications précédentes, **caractérisé en ce que** le dépôt sous vide de la couche filtrante optique comporte le dépôt d'une couche filtrante interférentielle.

32. Procédé selon l'une quelconque des revendications précédentes, **caractérisé en ce que** le dépôt sous vide de la couche filtrante optique est effectué au moins temporairement à une température de la surface masquée supérieure à 150°C, de préférence dans une plage supérieure à 150°C jusqu'à 400°C inclus.

33. Procédé selon la revendication 32, **caractérisé en ce que** la température de la surface masquée se situe au moins temporairement dans une plage de 170°C ± 15°C, de préférence dans une plage de 170°C ± 10°C.

34. Procédé selon l'une quelconque des revendications précédentes, **caractérisé en ce qu'**un revêtement est appliqué sur un segment en forme de segment de cercle de la surface.

35. Procédé selon l'une quelconque des revendications précédentes, **caractérisé en ce que** qu'un segment de couche filtrante optique est déposé, lequel est réalisé sous la forme d'une information visible, en particulier un graphisme, un symbole ou un logo.

36. Procédé selon l'une quelconque des revendications précédentes, **caractérisé en ce que** les étapes du masquage et du dépôt sous vide sont répétées au moins une fois, différents segments de la surface étant revêtus d'une couche filtrante optique au moyen d'un masquage différent.

37. Procédé selon la revendication 36, **caractérisé en ce que** les différents segments sont munis de différentes couches filtrantes optiques.

38. Procédé selon l'une quelconque des revendications précédentes, **caractérisé en ce qu'**un revêtement est appliqué sur un substrat en forme de verre pour une roue chromatique.

39. Procédé selon l'une quelconque des revendications précédentes, **caractérisé en ce qu'**un revêtement est appliqué sur un substrat en verre ou une surface en verre d'un substrat.

40. Utilisation d'un procédé selon l'une des revendications précédentes pour la réalisation d'un filtre optique segmenté.

41. Utilisation d'un procédé selon l'une des revendications précédentes pour la réalisation d'un capteur avec des surfaces de détection, parmi lesquelles au moins une est revêtue d'un segment de couche filtrante optique.

42. Utilisation d'un procédé selon l'une des revendications précédentes pour le revêtement de feuilles.

43. Utilisation d'un procédé selon l'une des revendications précédentes pour le revêtement de supports avec des motifs de décoration.
